Europäisches Patentamt

European Patent Office

Office européen des brevets

(19)

(11) Publication number: **0 435 308 A1**

## (12) EUROPEAN PATENT APPLICATION

(21) Application number: **90125654.5**

(22) Date of filing: **28.12.90**

(51) Int. Cl.⁵: **H01L 29/08, H01L 29/73**

(30) Priority: **28.12.89 JP 342408/89**

(43) Date of publication of application:
**03.07.91 Bulletin 91/27**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Katsumata, Yasuhiro, c/o Intell.**
**Property Div.**
**K. K. TOSHIBA, 1-1 Shibaura 1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Lateral semiconductor device.

(57) Only area of the emitter region of the lateral transistor, which faces the collector region, is formed in a closed-circuit shape and an unnecessary internal area of the emitter region is removed. As a result, the area of the emitter region is decreased without reducing the length of the circumferences of the emitter and collector regions in comparison with those of the emitter and collector regions of the conventional transistor. The parasitic capacitance of the lateral transistor is thus decreased to about 1/10 that of the conventional transistor, and the operating frequency of an analog IC device using the present lateral transistor is increased to about 3 that of the conventional IC device.

F I G. 3

EP 0 435 308 A1

# LATERAL SEMICONDUCTOR DEVICE

The present invention relates to a lateral semiconductor device and, more particularly, to a lateral semiconductor device which is incorporated into an IC device for performing a high-frequency operation.

A high-speed analog IC device including an NPN transistor and a pnp lateral transistor is known as one of high-speed bipolar devices. In most cases, the lateral pnp transistor contributes to a high-frequency operation of the IC device.

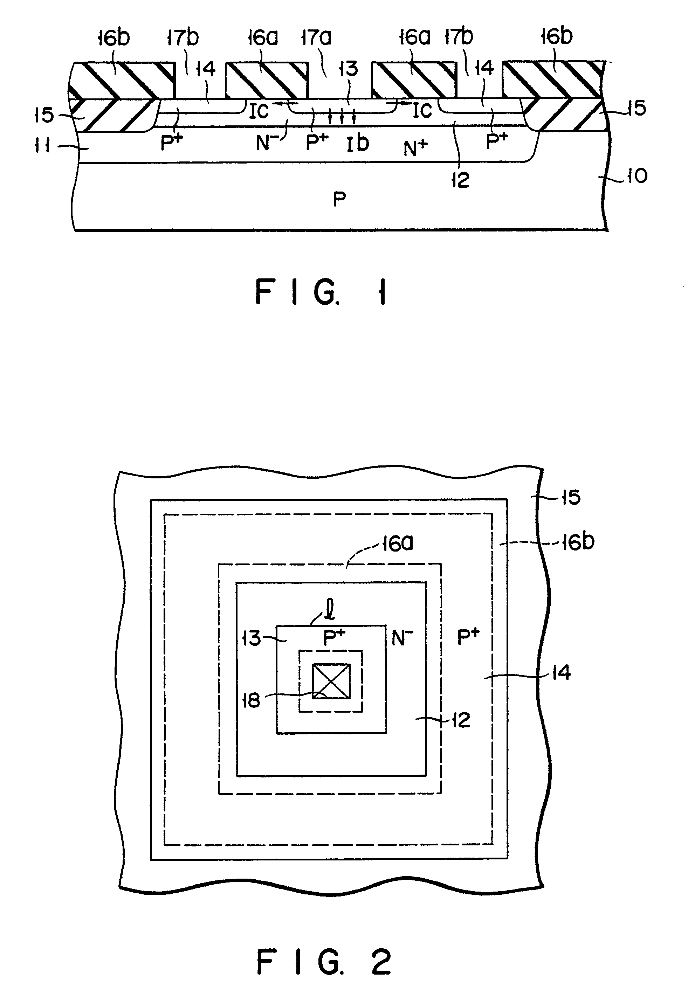

Fig. 1 is a cross-sectional view showing an arrangement of a conventional lateral PNP transistor. As shown in Fig. 1, an N-impurity is doped into P-silicon semiconductor substrate 10 to form an $N^+$-buried region 11. $N^-$-epitaxial layer 12 including phosphorus or the like is formed on the $N^+$-buried region 11 and serves as a base region of the lateral PNP transistor. Device isolation insulating layer 15 is formed around the epitaxial layer 12 by local oxidation of silicon (LOCOS) and then an oxide layer 16 is formed on a surface of the resultant structure by CVD method. The oxide layer 16 is patterned to form openings 17a and 17b for emitter and collector regions, using a lithography technique. A $P^+$-impurity such as phosphorus is introduced into the N--epitaxial layer 12 through the openings 17a and 17b by ion-implantation or diffusion method to form emitter and collector regions 13 and 14. Then an emitter electrode and a collector electrode are formed on the emitter and collector regions.

Fig. 2 is a plan view of the lateral PNP transistor shown in Fig. 1. In Fig. 2, reference numeral 18 denotes a contact hole for the emitter electrode.

In the lateral transistor, as shown in Fig. 1, collector currents Ic laterally flow from the emitter region 13 into the collector region 14, and base currents Ib vertically flow from the emitter region 13 into the $N^-$-epitaxial layer 12. A current gain $h_{fe}$ of the bipolar transistor is expressed by a ratio Ic/Ib. A collector current Ic is proportionate to a length $\ell$ of a circumference of the emitter region 13 and a base current Ib is proportionate to the area of the emitter region 13. Since an area of the emitter region 13 facing to the collector region 14 affects a supply of an effective current, the length $\ell$ of the circumference of the emitter region 13 needs to be made long in order to increase the collector current Ic. However, the longer the length $\ell$ of the circumference, the larger the parasitic capacitance of the emitter region 13. The lateral transistor is therefore prevented from operating at high frequency and the current gain is reduced. Accordingly, an analog IC device which is monolithically formed with the lateral transistor is also prevented from operating at high frequency.

The present invention has been made in consideration of the above situation, and its object is to provide a lateral semiconductor device in which the parasitic capacitance of a lateral transistor is reduced to operate a monolithic IC device at high frequency.

According to one aspect of the present invention, there is provided a lateral semiconductor device, said device comprising:

a semiconductor substrate of a first conductivity type;

a buried region of a second conductivity type formed in the semiconductor substrate;

a semiconductor layer of the second conductivity type formed on the buried region and having a lower impurity concentration than that of the buried region;

a device isolation insulating layer formed around the semiconductor layer;

an insulating layer formed in a central area of the semiconductor layer inside the device isolation insulating layer and separated from the device isolation insulating layer;

a first impurity region of the first conductivity type formed in a closed-circuit shape along an end portion of the insulating layer; and

a second impurity region of the first conductivity type formed in a closed-circuit shape along an end portion of the device isolation insulating layer.

According to another aspect of the present invention, there is provided a lateral semiconductor device, said device comprising:

a semiconductor substrate of a first conductivity type;

a buried region of a second conductivity type formed in the semiconductor substrate;

a semiconductor layer of the second conductivity type formed on the buried region and having a lower impurity concentration than that of the buried region;

a device isolation insulating layer formed around the semiconductor layer;

a first insulating layer formed in a closed-circuit shape on a surface of the semiconductor layer and in contiguity with the device isolation insulating layer, the first insulating layer being thinner than the device isolation insulating layer;

a second insulating layer formed in a central area of the semiconductor layer inside the first insulating layer and separated from the first insulating layer, the second insulating layer being thinner than the device isolation insulating layer;

a first impurity region of the first conductivity type formed in a closed-circuit shape along an end portion of the first insulating layer; and
a second impurity region of the first conductivity type in a closed-circuit shape along an end portion of the second insulating layer.

According to the present invention, only area of the emitter region of the lateral transistor, which faces the collector region, is formed in a closed-circuit shape and an unnecessary internal area of the emitter region is removed. As a result, the area of the emitter region is decreased without reducing the lengths of the circumferences of the emitter and collector regions in comparison with those of the emitter and collector regions of the conventional transistor. The parasitic capacitance of the lateral transistor is thus decreased to about 1/10 that of the conventional transistor, and the operating frequency of an analog IC device using the present lateral transistor is increased to about 3 that of the conventional IC device.

This invention can be more fully understood from the following detailed description when taken in conjunction with the accompanying drawings, in which:

Fig. 1 is a cross-sectional view showing an arrangement of a conventional lateral PNP transistor;

Fig. 2 is a plan view of the lateral PNP transistor shown in Fig. 1;

Fig. 3 is a cross-sectional view showing an arrangement of a first embodiment of a lateral transistor according to the present invention; and

Fig. 4 is a cross-sectional view showing an arrangement of a second embodiment of a lateral transistor according to the present invention.

Embodiments of the lateral semiconductor device according to the present invention will be described with reference to the accompanying drawings.

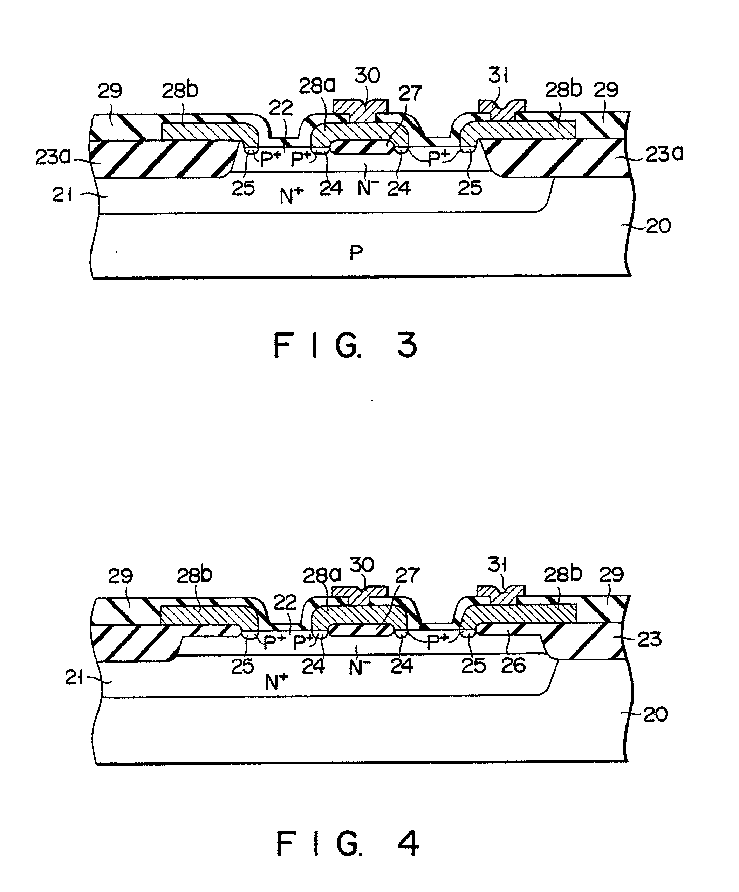

Fig. 3 is a cross-sectional view showing an arrangement of a first embodiment of a lateral semiconductor device according to the present invention. The lateral transistor is monolithically formed with an analog IC device. An $N^+$-region serving as a buried region 21 of the lateral transistor is formed on the surface of silicon semiconductor substrate 20 containing boron of about $4 \times 10^{14}/cm^3$. More particularly, an N-impurity such as antimony or arsenic is doped into an oxide layer (not shown) formed on the surface of the substrate 20 through an opening which is formed by a lithography technique, thereby forming an $N^+$-buried layer 21. The oxide layer is then removed, and an $N^-$-epitaxial layer 22 having a thickness of about 1.0 $\mu$m is formed by epitaxial growth method. The $N^-$-epitaxial layer 22 contains phosphorus and serves as a base region of the lateral transistor. The impurity concentration of the $N^-$-epitaxial layer 22 is approximately $10^{16}/cm^3$.

After forming the $N^-$-epitaxial layer 22, a selective oxidation layer 23a, i.e., a device isolation insulating layer 23a having a thickness of 11000 to 13000 Å is formed in a predetermined area, using, as a mask, a silicon nitride (not shown). The layer 23a is necessary for the analog IC device for electrically isolating the semiconductor devices. Then the silicon nitride is removed and, as shown in Fig. 3, the insulating layer 23a is formed around the $N^-$-epitaxial layer 22, resulting in isolation of the devices. An insulating layer 27 which is thinner than the insulating layer 23a, is formed in the central area of $N^-$-epitaxial layer 22 by the epitaxial growth method or thermal oxidation. As described later, a $P^+$-emitter region 24 is formed in a closed-circuit shape along an end portion of the insulating layer 27, and a $P^+$-collector region 25 is also formed in a closed-circuit shape along an end portion of the insulating layer 23a. In particular, both emitter and collector regions 24 and 25 are formed annularly, rectangularly, oblongly or the like.

A polysilicon layer 28 including a P-impurity such as boron of about $5 \times 10^{19}/cm^3$ is deposited on the entire surface of the resultant structure by low pressure CVD. Then the polysilicon layer 28 undergoes a patterning operation to form polysilicon layers 28a and 28b on regions for forming the emitter and collector regions 24 and 25 and on the insulating layer 27. A CVD film 29 having a thickness of 3000 to 4000 Å is formed on the entire surface of the resultant structure by the CVD. The resultant structure is thermally treated to diffuse the borons included in the polysilicon layer 28 into the $N^-$-epitaxial layer 22, thereby forming the emitter and collector regions 24 and 25 each having an impurity concentration of about $10^{19}/cm^3$ which is 1/5 that of the polysilicon layer 28. The CVD film 29 can also be heated in this step.

Openings are then formed through the CVD film 29 to reach predetermined portions of the polysilicon layer 28a of the emitter region 24 and the polysilicon layer 28b of the collector region 25. A conductive metal such as aluminum or aluminum alloy (Aℓ - Si, Aℓ - Si - Cu, etc.) is deposited in the openings to form an emitter electrode 30 and a collector electrode 31. The emitter electrode 30 is connected to the emitter region 24 through the polysilicon layer 28a, and the collector electrode 31 is connected to the collector region 25 through the polysilicon layer 28b. An electrode (not shown) for the $N^-$-epitaxial layer 22 is formed by connecting the $N^+$-buried region 21 to an IC device isolating layer (not shown) which is monolithically formed in the silicon semiconductor substrate 20 with the lateral transistor. Finally, a silicon dioxide $SiO_2$

layer, a silicon nitride layer, or a layer consisting of these two layers is formed as an on-Aℓ passivation layer, thereby completing the lateral semiconductor device of the first embodiment according to the present invention.

Fig. 4 is a cross-sectional view showing an arrangement of a second embodiment of a lateral transistor according to the present invention. According to the second embodiment, after the device isolation insulating film 23 is formed, an insulating layer 27 which is thinner than the insulating layer 23 is formed in the central area of the N⁻-epitaxial layer 22 and, at the same time, an insulating layer 26 whose thickness is the same as that of the insulating layer 27 is formed in contiguity with the insulating layer 23 in a closed-circuit shape by the CVD or thermal oxidation. A P⁺-collector region 25 is formed in a closed-circuit shape along an end portion of the thin insulating layer 26. The other layers and regions are formed as in the first embodiment.

As described above, in the lateral semiconductor device according to the present invention, the emitter region is formed in a closed-circuit shape so that only a peripheral area of the emitter region faces the collector region, and the length of the circumference of the collector region is set to be equal to that of the collector region of a conventional transistor. The parasitic capacitance of the lateral transistor is thus reduced to about 1/10 that of the conventional transistor, and the operating frequency of an analog IC device using the present lateral transistor is increased to about 3 that of a conventional IC device.

Reference signs in the claims are intended for better understanding and shall not limit the scope.

## Claims

1. A lateral semiconductor device comprising:
   a semiconductor substrate (20) of a first conductivity type;
   a buried region (21) of a second conductivity type formed in said semiconductor substrate (20);
   a semiconductor layer (22) of the second conductivity type formed on said buried region (21) and having a lower impurity concentration than that of said buried region (21);
   a device isolation insulating layer (23a) formed around said semiconductor layer (22);
   an insulating layer (27) formed in a central area of said semiconductor layer (22) inside said device isolation insulating layer (23a) and separated from said device isolation insulating layer (23a);
   a first impurity region (24) of the first conductivity type formed in a closed-circuit shape along an end portion of said insulating layer (27); and
   a second impurity region (25) of the first conductivity type formed in a closed-circuit shape along an end portion of said device isolation insulating layer (23a).

2. The lateral semiconductor device according to claim 1, characterized in that said device isolation insulating layer (23a) and said thin insulating layer (27) are rectangularly formed, and said first and second impurity regions (24, 25) are hollowly and rectangularly formed.

3. The lateral semiconductor device according to claim 1, characterized in that said device isolation insulating layer (23a) and said thin insulating layer (27) are oblongly formed, and said first and second impurity regions (24, 25) are hollowly and oblongly formed.

4. The lateral semiconductor device according to claim 1, characterized in that said device isolation insulating layer (23a) and said thin insulating layer (27) are circularly formed, and said first and second impurity regions (24, 25) are annularly formed.

5. A lateral semiconductor device comprising:
   a semiconductor substrate (20) of a first conductivity type;
   a buried region (21) of a second conductivity type formed in said semiconductor substrate (20);
   a semiconductor layer (22) of the second conductivity type formed on said buried region (21) and having a lower impurity concentration than that of said buried region (21);
   a device isolation insulating layer (23) formed around said semiconductor layer (22);
   a first insulating layer (26) formed in a closed-shape on a surface of said semiconductor layer (22) and in contiguity with said device isolation insulating layer (23), said first insulating layer (26) being thinner than said device isolation insulating layer (23);
   a second insulating layer (27) formed in a central area of said semiconductor layer (22) inside said first insulating layer (26) and separated from said first insulating layer (26), said second insulating layer (27) being thinner than said device isolation insulating layer (23);
   a first impurity region (25) of the first conductivity type formed in a closed-circuit shape along an end portion of said first insulating layer (26); and
   a second impurity region (24) of the first conductivity type formed in a closed-circuit shape along an end portion of said second insulating layer (27).

6. The lateral semiconductor device according to claim 5, characterized in that said first and second insulating layers (26, 27) are rectangularly formed, and said first and second impurity regions (24, 25) are hollowly and rectangularly formed. `

7. The lateral semiconductor device according o claim 5, characterized in that said first and second insulating layers (26, 27) are oblongly formed, and said first and second impurity regions (24, 25) are hollowly and oblongly formed.

8. The lateral semiconductor device according to claim 5, characterized in that said first and second insulating layers (26, 27) are circularly formed, and said first and second impurity regions (24, 25) are annularly formed.

F I G. 1

F I G. 2

F I G. 3

F I G. 4

**EUROPEAN SEARCH
REPORT**

**EP 90 12 5654**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 100 897 (IBM)<br>* figures 5,6; page 9, lines 14-34 *<br>— — — | 1,2,5,6 | H 01 L 29/08<br>H 01 L 29/73 |
| A | | 3,4,7,8 | |
| X | EP-A-0 137 906 (IBM)<br>* figures 10-13; page 19, line 11 - page 21, line 17 *<br>— — — | 1,3,5,7 | |
| A | . | 2,4,6,8 | |
| | — — — — — | | |

TECHNICAL FIELDS
SEARCHED (Int. Cl.5)

H 01 L

The present search report has been drawn up for all claims

| Place of search | Date of completion of search | Examiner |
|---|---|---|
| Berlin | 02 April 91 | JUHL A. |

CATEGORY OF CITED DOCUMENTS
X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document